# DEMANDE DE BREVET EUROPEEN

(11) **EP 4 498 511 A1**
(43) Date de publication de la demande: **29.01.2025**
(21) Numéro de dépôt: 24190971.2
(22) Date de dépôt: 25.07.2024
(51) Int. Cl.: H01P 5/22, H03H 7/48

(54) **COUPLEUR HYBRIDE A QUATRE-VINGT-DIX DEGRES**

(30) Priorité: 27.07.2023 FR 2308118
(71) Demandeur: STMicroelectronics International N.V., 1228 Plan-les-Ouates, Geneva (CH)
(72) Inventeur: KNOPIK, Vincent, 38830 CRETS EN BELLEDONNE (FR)
(74) Mandataire: Cabinet Beaumont

(57) **Abrégé**

La présente description concerne un coupleur comprenant un premier assemblage (400) d'un élément unitaire d'entrée (401), d'un élément unitaire intermédiaire (402), et d'un élément unitaire de sortie (403), chaque élément unitaire comprenant une première bobine et une deuxième bobine disposées en croix ayant une forme générale de "H", dans lequel :
- une première borne d'entrée et une deuxième borne d'entrée de l'élément unitaire intermédiaire (402) sont reliées à une première borne de sortie et à une deuxième borne de sortie de l'élément unitaire d'entrée (401) ;
- une première borne de sortie et une deuxième borne de sortie de l'élément unitaire intermédiaire (402) sont reliées à une première borne d'entrée et à une deuxième borne d'entrée de l'élément unitaire de sortie (403), et
dans lequel l'élément unitaire d'entrée (401) est positionné spatialement entre l'élément unitaire intermédiaire (402) et l'élément unitaire de sortie (403).

## Description

### Domaine technique

La présente description concerne de façon générale les circuits et dispositifs électroniques adaptés à utiliser des signaux, et en particulier des signaux radiofréquence. La présente description se rapporte à un coupleur hybride, et plus particulièrement à un coupleur hybride à quatre-vingt-dix degrés.

### Technique antérieure

Les coupleurs sont des dispositifs électroniques utilisés pour coupler plusieurs signaux électroniques, et par exemple des signaux utilisés dans le domaine des radiofréquence, c'est-à-dire des signaux ayant des fréquences comprises entre quelques hertz et plus de 300 kHz, par exemple comprises entre 3 kHz et 300 GHz.

Il serait souhaitable de pouvoir améliorer, au moins en partie, certains aspects des coupleurs, et en particulier des coupleurs hybrides.

### Résumé de l'invention

Il existe un besoin pour des coupleurs plus performants.

Il existe un besoin pour des coupleurs présentant un encombrement moindre.

Un mode de réalisation pallie tout ou partie des inconvénients des coupleurs connus.

Un mode de réalisation prévoit un coupleur présentant un encombrement moindre.

Un mode de réalisation prévoit un coupleur ayant moins de pertes de signal.

Un mode de réalisation prévoit un coupleur comprenant un premier assemblage d'un élément unitaire d'entrée, d'un élément unitaire intermédiaire, et d'un élément unitaire de sortie, chaque élément unitaire comprenant :
- une première bobine et une deuxième bobine disposées en croix ayant une forme générale de "H" ;
- une première borne d'entrée correspondant à un noeud d'entrée de la première bobine ;
- une deuxième borne d'entrée correspondant à un noeud de sortie de la deuxième bobine ;
- une première borne de sortie correspondant à un noeud de sortie de la première bobine ;
- une deuxième borne de sortie correspondant à un noeud d'entrée de la deuxième bobine ;
   dans lequel :
- la première borne d'entrée de l'élément unitaire intermédiaire est reliée à la première borne de sortie de l'élément unitaire d'entrée ;
- la deuxième borne d'entrée de l'élément unitaire intermédiaire est reliée à la deuxième borne de sortie de l'élément unitaire d'entrée ;
- la première borne de sortie de l'élément unitaire intermédiaire est reliée à la première borne d'entrée de l'élément unitaire de sortie ; et
- la deuxième borne de sortie de l'élément unitaire intermédiaire est reliée à la deuxième borne d'entrée de l'élément unitaire de sortie, et
   dans lequel l'élément unitaire d'entrée est positionné spatialement entre l'élément unitaire intermédiaire et l'élément unitaire de sortie.

Selon un mode de réalisation, la première borne d'entrée de l'élément unitaire d'entrée est une première entrée dudit premier assemblage, et la deuxième borne d'entrée de l'élément unitaire d'entrée est une deuxième entrée dudit premier assemblage.

Selon un mode de réalisation, la première borne de sortie de l'élément unitaire de sortie est une première sortie dudit premier assemblage, et la deuxième borne de sortie de l'élément unitaire de sortie est une deuxième sortie dudit premier assemblage.

Selon un mode de réalisation, la première entrée dudit assemblage est configurée pour recevoir un premier signal, et la deuxième entrée dudit assemblage est configurée pour recevoir un deuxième signal égale au premier signal déphasé.

Selon un mode de réalisation, le deuxième signal est le premier signal déphasé de quatre-vingt-dix degrés.

Selon un mode de réalisation, le deuxième signal est le premier signal déphasé de cent quatre-vingt degrés.

Selon un mode de réalisation, le coupleur comprend au moins un deuxième assemblage identique au premier assemblage, dans lequel la première sortie dudit premier assemblage est reliée à une première entrée dudit deuxième assemblage, et la deuxième sortie dudit premier assemblage est reliée à une deuxième entrée dudit deuxième assemblage.

Selon un mode de réalisation, lesdits éléments unitaires ont tous les mêmes dimensions.

Selon un mode de réalisation, lesdits éléments unitaires ont des dimensions différentes.

Selon un mode de réalisation, lesdits éléments unitaires sont tous placés dans un même plan.

Selon un mode de réalisation, lesdits éléments unitaires sont tous placés dans des plans différents.

Selon un mode de réalisation, lesdits éléments unitaires sont placés en forme d'escalier.

Selon un mode de réalisation, les premiers et deuxièmes bobines desdits éléments unitaires sont des enroulements de forme générale rectangulaire.

Selon un mode de réalisation, les premiers et deuxièmes bobines desdits éléments unitaires sont des enroulements de forme générale en zig-zag.

Selon un mode de réalisation, le coupleur est un coupleur réversible.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un symbole électrique et un schéma électrique équivalent d'un mode de réalisation d'un coupleur hybride ;
la figure 2 représente en vue de dessus un élément unitaire formant un coupleur selon le mode de réalisation de la figure 1 ;
la figure 3 représente de façon schématique un exemple d'assemblage d'éléments unitaires de la figure 2 ;
la figure 4 représente de façon schématique un mode de réalisation d'un assemblage d'éléments de la figure 2 formant le coupleur de la figure 1 ;
la figure 5 représente de façon schématique un autre mode de réalisation utilisant deux assemblage de la figure 2 pour former le coupleur de la figure 1 ;
la figure 6 représente une vue de dessus d'un exemple pratique de réalisation du mode de réalisation de la figure 5 ; et
la figure 7 représente une vue de dessus d'un autre exemple pratique de réalisation du mode de réalisation de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

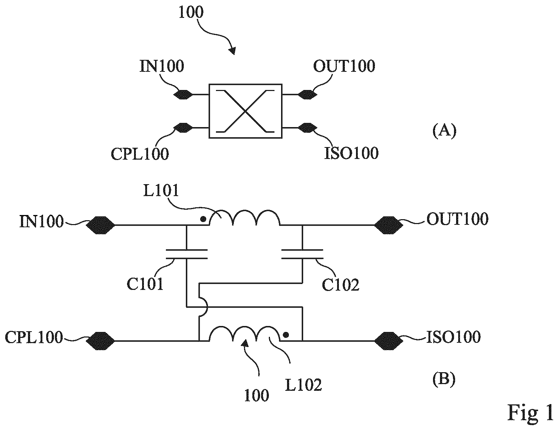

La figure 1 représente des schémas (A) et (B) d'un coupleur 100 selon un mode de réalisation. Le schéma (A) représente le symbole électrique du coupleur 100, et le schéma (B) représente un schéma électrique équivalent du coupleur 100.

Selon un mode de réalisation, le coupleur 100 est un coupleur hybride. Selon un exemple préféré, le coupleur 100 est un coupleur hybride à quatre-vingt-dix degrés. Pour cela, le coupleur 100 comprend :
- une première entrée IN100 adaptée à recevoir un premier signal ;
- une deuxième entrée CPL100 adaptée à recevoir un deuxième signal ;
- une première sortie OUT100 adaptée à fournir un troisième signal ; et
- une deuxième sortie ISO100 adaptée à fournir un quatrième signal.

Selon un mode de réalisation, le deuxième signal est égal au premier signal déphasé. Selon l'exemple préféré, le deuxième signal est égal au premier signal déphasé de quatre-vingt-dix degrés. Selon un autre exemple accessible à la personne du métier, le deuxième signal est égal au premier signal déphasé de cent quatre-vingt degrés.

Lorsque le coupleur 100 est un coupleur hybride à quatre-vingt-dix degrés, le troisième signal, fournit la sortie OUT100, correspond à la somme des signaux reçus en entrée, et le quatrième signal est un signal nul.

Selon un mode de réalisation, le coupleur 100 est réversible, et en inversant les entrées et les sorties peut être un circuit séparateur de signaux.

Le coupleur 100 comprend deux bobines L101 et L102 et deux condensateurs C101 et C102.

En figure 1, la borne d'entrée d'une bobine est représentée par un point de phase, et la borne de sortie est laissée sans point de phase. Cela signifie que le courant traversant la bobine la traverse de la borne d'entrée vers la borne de sortie.

Selon un mode de réalisation, un noeud d'entrée de la bobine L101 est relié, de préférence connecté, à l'entrée IN100 du coupleur 100, et un noeud de sortie de la bobine L101 est relié, de préférence connecté, à la sortie OUT100 du coupleur 100. Un noeud d'entrée de la bobine L102 est relié, de préférence connecté, à la sortie ISO100 du coupleur 100, et un noeud de sortie de la bobine L102 est relié, de préférence connecté, à la sortie OUT100 du coupleur 100.

Selon un mode de réalisation, un premier noeud du condensateur C101 est relié, de préférence connecté, à l'entrée IN100 du coupleur 100, et un deuxième noeud du condensateur C101 est relié, de préférence connecté, à la sortie ISO100 du coupleur 100. Selon un mode de réalisation, un premier noeud du condensateur C102 est relié, de préférence connecté, à l'entrée CPL100 du coupleur 100, et un deuxième noeud du condensateur C102 est relié, de préférence connecté, à la sortie OUT100 du coupleur 100.

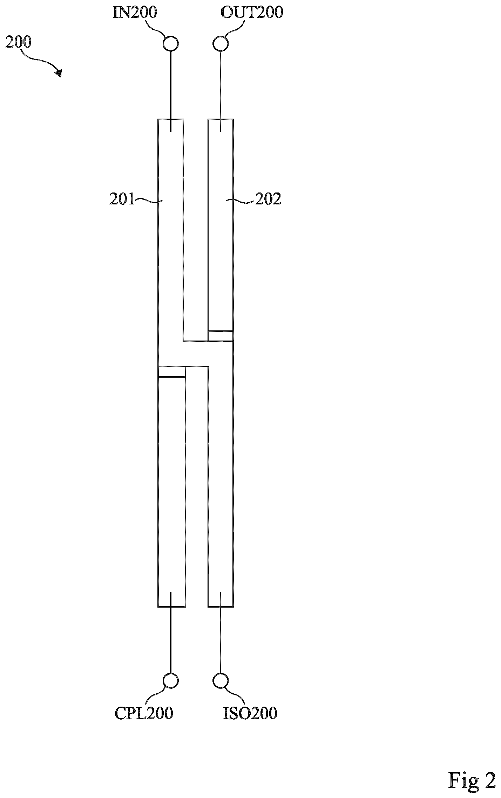

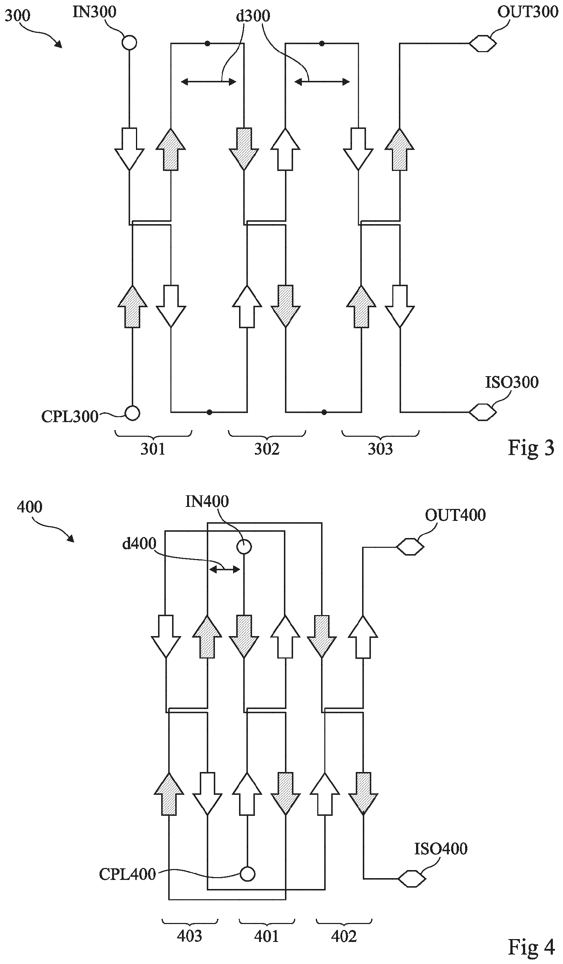

Une implémentation physique du coupleur 100 est décrite en relation avec la figure 2, et des assemblages de ces implémentations formant un coupleur sont décrites en relation avec les figures 4 à 7.

La figure 2 est une vue de dessus d'une implémentation physique du coupleur 100 décrit en relation avec la figure 1. Plus particulièrement, la figure 2 est une vue de dessus d'un élément unitaire 100 permettant de former le coupleur 100.

L'élément unitaire 100 comprend deux bobines 201 et 202 disposées sous forme de croix ou de "x". Plus particulièrement, la première bobine 201 forme une première branche de la croix, ou du "x", et la deuxième bobine 202 forme une deuxième branche de la croix, ou du "x".

Plus particulièrement, les deux bobines 201 sont disposées sous une forme de croix ayant une forme générale de "H". Autrement dit, toutes les branches de la croix formée par les bobines 201 et 202 suivent une même direction, et sont ainsi parallèles entre elles. Ainsi, on appelle ici une croix ayant une forme générale de "H", la forme prise par les bobines 201 et 202 représentée en figure 2.

L'élément unitaire 200 comprend deux bornes entrées et deux bornes sorties similaires aux entrées et sorties du coupleur 100. Plus particulièrement, l'élément unitaire 200 comprend :
- une première borne d'entrée IN200 correspondant à un noeud d'entrée de la bobine 201 ;
- une deuxième borne d'entrée CPL200 correspondant à un noeud de sortie de la bobine 202 ;
- une première borne de sortie OUT200 correspondant à un noeud sortie de la bobine 202 ; et
- une deuxième borne de sortie ISO200 correspondant à un noeud d'entrée de la bobine 202.

Les condensateurs du coupleur sont formés de fait entre les branches de la croix des bobines 201 et 202. Plus particulièrement, les condensateurs représentent les capacités intrinsèques des branches de la croix formées par les bobines. Selon une variante, des condensateurs peuvent être rajoutés à la structure présentée en figure 2.

Plus particulièrement, les première et deuxième bornes d'entrée IN200 et CPL200 sont disposées toutes les deux sur une même branche de la forme générale en "H" de la croix de l'élément unitaire 200. De même, les première et deuxième bornes de sortie OUT200 et ISO200 sont disposées toutes les deux sur l'autre branche de la forme générale en "H" de la croix de l'élément unitaire 200. Dit autrement, les première et deuxième bornes d'entrée IN200 et CPL200 sont disposées du même côté (côté gauche en figure 1) sur un premier grand côté de l'élément unitaire, les première et deuxième bornes de sortie OUT200 et ISO200 sont disposées du même côté (côté droit en figure 1) sur l'autre grand côté de l'élément unitaire 200. Dit encore autrement, les première et deuxième bornes d'entrée IN200 et CPL200 ne sont pas disposées sur des branches différentes de la forme générale de "H" de la croix de l'élément unitaire 200. De même, les première et deuxième bornes de sortie OUT200 et ISO200 ne sont pas disposées sur des branches différentes de la forme générale de "H" de la croix de l'élément unitaire 200.

Les dimensions de l'élément unitaire 200 permettent de définir les caractéristiques électriques du coupleur, comme les inductances des bobines 201 et 202 et les capacités des condensateurs. Il convient donc d'adapter les dimensions de l'élément unitaire 200 pour ajuster les fonctionnalités du coupleur qu'il forme.

Un élément unitaire 200 permet de mettre en oeuvre un coupleur du type du coupleur 100, mais il est aussi possible d'assembler plusieurs éléments unitaires 200 pour obtenir un coupleur du type du coupleur 100. Un avantage d'assembler plusieurs éléments unitaires 200 pour former est que cela permet de limiter l'encombrement d'un coupleur 100 tout en permettant de lui donner différentes formes. Un premier exemple d'un assemblage d'éléments unitaires 200 est décrit en relation avec la figure 3, mais cet assemblage présente des inconvénients. Un mode de réalisation d'un assemblage palliant ces inconvénients est décrit en relation avec la figure 4.

La figure 3 représente, très schématiquement, un exemple d'un assemblage 300 d'éléments unitaires du type de l'élément unitaire 200 décrit en relation avec la figure 2.

En figure 3, chaque élément unitaire est représenté très schématiquement par leur forme générale représenté sous forme de fil. De plus, les courants des signaux appliqués au bornes d'entrée des éléments unitaires, et leurs sens, sont représentés par des flèches. Comme deux signaux différents sont appliqués au niveau des bornes d'entrée des éléments unitaires, deux "couleurs" de flèches sont utilisées pour les différencier.

L'assemblage 300 forme un coupleur du type du coupleur 100 décrit en relation avec la figure 1, et comprend donc deux entrées IN300 et CPL300, et deux sorties OUT300 et ISO300.

L'assemblage 300 comprend trois éléments unitaires parmi lesquels :
- un élément unitaire d'entrée 301 ;
- un élément unitaire intermédiaire 302 ; et
- un élément unitaire de sortie 303.

L'élément unitaire d'entrée 301 est caractérisé en ce que ses bornes d'entrée sont reliées aux entrées de l'assemblage. Plus particulièrement, une première borne d'entrée de l'élément 301 est reliée, de préférence connectée, à l'entrée IN300 de l'assemblage, et une deuxième borne d'entrée de l'élément 301 est reliée, de préférence connectée, à l'entrée CPL300 de l'assemblage.

L'élément unitaire de sortie 303 est caractérisé en ce que ses bornes de sortie sont reliées aux sorties de l'assemblage 300. Plus particulièrement, une première borne de sortie de l'élément 303 est reliée, de préférence connectée, à la sortie OUT300 de l'assemblage 300, et une deuxième borne de sortie de l'élément 303 est reliée, de préférence connectée, à la sortie ISO300 de l'assemblage 300.

L'élément unitaire intermédiaire 302 est caractérisé en ce qu'il est positionné entre les éléments unitaires d'entrée 301 et de sortie 303. Plus particulièrement, une première borne d'entrée de l'élément 302 est reliée, de préférence connectée, à une première borne de sortie de l'élément 301, et une deuxième borne d'entrée de l'élément 302 est reliée, de préférence connectée, à une deuxième borne de sortie de l'élément 301. Une première borne de sortie de l'élément 302 est reliée, de préférence connectée, à une première borne d'entrée de l'élément 303, et une deuxième borne de sortie de l'élément 302 est reliée, de préférence connectée, à une deuxième borne d'entrée de l'élément 303.

Un inconvénient de l'assemblage 300 est que le positionnement des éléments unitaires présente des contraintes qui peuvent augmenter l'aire occupée par l'assemblage 300. En particulier, des phénomènes de couplage parasites peuvent apparaître aux niveaux des connexions entre les éléments unitaires. En effet, comme décrit précédemment, les éléments unitaires sont formés par des bobines, et, au niveau des connexions entre les éléments unitaires, deux bobines côte à côte sont disposées en parallèle et sont traversées par le même courant mais dans des sens différents, comme représenté en figure 3. Pour éviter ces phénomènes de couplage parasites, les éléments unitaires doivent être espacés d'une distance d300, ce qui augmente l'encombrement.

La figure 4 représente, très schématiquement, un mode de réalisation d'un assemblage 400 d'éléments unitaires du type de l'élément unitaire 200 décrit en relation avec la figure 2.

L'assemblage 400 forme un coupleur du type du coupleur 100 décrit en relation avec la figure 1, et comprend donc deux entrées IN400 et CPL400, et deux sorties OUT400 et ISO400.

L'assemblage 400 comprend trois éléments unitaires parmi lesquels :
- un élément unitaire d'entrée 401 ;
- un élément unitaire intermédiaire 402 ; et
- un élément unitaire de sortie 403.

L'élément unitaire d'entrée 401 est caractérisé en ce que ses bornes d'entrée sont reliées aux entrées de l'assemblage. Plus particulièrement, une première borne d'entrée de l'élément 401 est reliée, de préférence connectée, à l'entrée IN400 de l'assemblage 400, et une deuxième borne d'entrée de l'élément 401 est reliée, de préférence connectée, à l'entrée CPL400 de l'assemblage 400.

L'élément unitaire de sortie 403 est caractérisé en ce que ses bornes de sortie sont reliées aux sorties de l'assemblage 400. Plus particulièrement, une première borne de sortie de l'élément 403 est reliée, de préférence connectée, à la sortie OUT400 de l'assemblage 400, et une deuxième borne de sortie de l'élément 403 est reliée, de préférence connectée, à la sortie ISO400 de l'assemblage 400.

L'élément unitaire intermédiaire 402 est caractérisé en ce qu'il est relié aux éléments unitaires d'entrée 401 et de sortie 403. Plus particulièrement, une première borne d'entrée de l'élément 402 est reliée, de préférence connectée, à une première borne de sortie de l'élément 401, et une deuxième borne d'entrée de l'élément 402 est reliée, de préférence connectée, à une deuxième borne de sortie de l'élément 401. Une première borne de sortie de l'élément 402 est reliée, de préférence connectée, à une première borne d'entrée de l'élément 403, et une deuxième borne de sortie de l'élément 402 est reliée, de préférence connectée, à une deuxième borne d'entrée de l'élément 403.

Selon un mode de réalisation, l'élément unitaire d'entrée 401 est disposé spatialement entre l'élément unitaire intermédiaire 402 et l'élément unitaire de sortie 403. Autrement dit l'élément unitaire d'entrée 401 est positionné physiquement entre l'élément unitaire intermédiaire 402 et l'élément unitaire de sortie 403, sans modifier les connexions entre les éléments unitaires.

Ce mode de réalisation présente plusieurs avantages.

Un premier avantage est qu'il permet d'augmenter la distance entre les éléments unitaires consécutifs, tout en optimisant la place perdue entre les éléments unitaires. Seul une distance minimale d400 est imposé entre l'élément unitaire d'entrée et l'élément unitaire intermédiaire pour éviter un phénomène de couplage parasite moins intense que ceux présent dans l'assemblage 300 de la figure 3.

Un second avantage est qu'il permet d'éviter d'avoir côte à côte des bobines traversées par le même courant, et dont d'éviter l'apparition de phénomènes de couplage parasites.

Un troisième avantage est qu'il permet d'avoir un nouveau couplage entre les deux signaux d'entrée, ce couplage étant visible en figure 4 entre l'élément unitaire 401 et l'élément unitaire 403. En effet, comme représenté en figure 4, deux bobines traversées chacune par un courant différent sont mises côte à côté. Ajouter ce couplage permet de diminuer les pertes du coupleur formé par l'assemblage 400, et donc d'améliorer ses performances.

Par ailleurs, il est à noter que les éléments unitaires 401, 402 et 403 représentés schématiquement en figure 4 présentent tous des dimensions similaires, mais, selon une variante, les éléments unitaires 401, 402, et 403 peuvent présenter des dimensions différentes, et, en particulier, des longueurs d'éléments unitaires différentes.

De plus, en figure 4 et pour simplifier la compréhension, les éléments unitaires 401, 402 et 403 sont représentés dans un même plan. Cependant, la personne du métier saura disposer les éléments unitaires 401, 402 et 403 dans un modèle en trois dimensions. Ainsi, il est possible de disposer les éléments unitaires les uns au-dessus des autres en forme d'escalier.

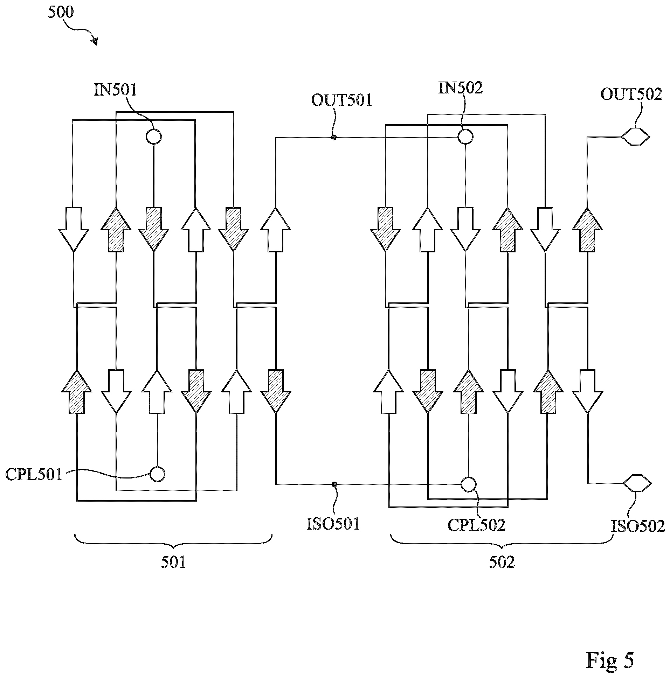

La figure 5 représente, très schématiquement un coupleur 500 selon un mode de réalisation.

Le coupleur 500 comprend deux assemblages 501 et 502 du type de l'assemblage 400 décrit en relation avec la figure 4.

L'assemblage 501 comprend :
- une première borne d'entrée IN501 ;
- une deuxième borne d'entrée CPL501 ;
- une première borne de sortie OUT501 ; et
- une deuxième borne de sortie ISO501.

L'assemblage 502 comprend :
- une première borne d'entrée IN502 ;
- une deuxième borne d'entrée CPL502 ;
- une première borne de sortie OUT502 ; et
- une deuxième borne de sortie ISO502.

Pour former le coupleur 500, les assemblages 501 et 502 sont connectés "en série". Autrement dit, la borne de sortie OUT501 de l'assemblage 501 est reliée, de préférence connectée, à la borne d'entrée IN502 de l'assemblage 502, et la borne de sortie ISO501 de l'assemblage 501 est reliée, de préférence connectée, à la borne d'entrée CPL502 de l'assemblage 502.

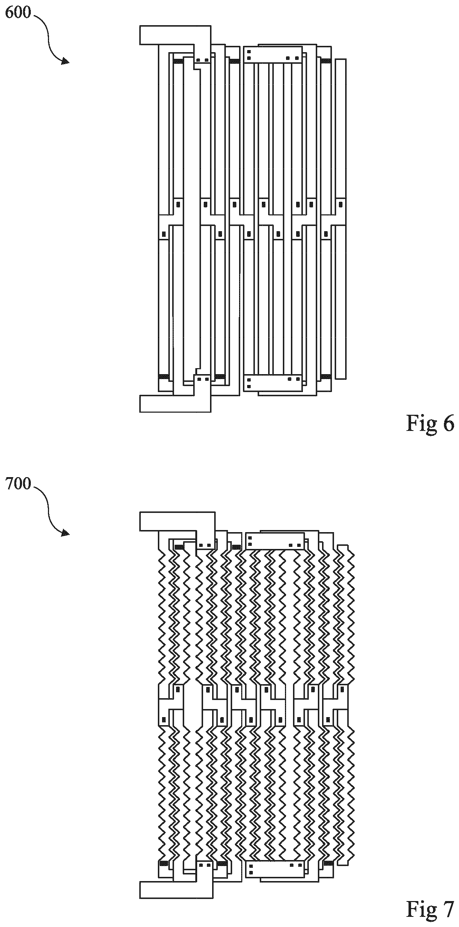

Les figures 6 et 7 représentent des vues de dessus d'exemples pratiques de mise en oeuvre du coupleur 500 décrit en relation avec la figure 5. Plus particulièrement, la figure 6 représente un coupleur 600, et la figure 7 représente un coupleur 700.

La différence entre les coupleurs 600 et 700 est que le coupleur 700 présente des bobines en forme de zig-zag alors que le coupleur 600 présente des bobines de forme générale rectangulaire. Ces bobines présentent l'avantage d'améliorer les performances de couplage du coupleur 700. En effet, lorsque les éléments unitaires des assemblages du coupleur 700 sont repliés en zig-zag, les couplages avantageux, c'est-à-dire les couplages voulus par le coupleur, sont augmentés, et les couplages désavantageux, c'est-à-dire les couplages à éviter sont réduits.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Coupleur (100 ; 400 ; 500 ; 600 ; 700) comprenant un premier assemblage (400 ; 501) d'un élément unitaire d'entrée (401), d'un élément unitaire intermédiaire (402), et d'un élément unitaire de sortie (403), chaque élément unitaire (200) comprenant :
- une première bobine (201, 202) et une deuxième bobine (202, 201) disposées en croix ayant une forme générale de "H" ;
- une première borne d'entrée (IN200) correspondant à un noeud d'entrée de la première bobine (201, 202) ;
- une deuxième borne d'entrée (CPL200) correspondant à un noeud de sortie de la deuxième bobine (202, 201) ;
- une première borne de sortie (OUT200) correspondant à un noeud de sortie de la première bobine (201, 202) ;
- une deuxième borne de sortie (ISO200) correspondant à un noeud d'entrée de la deuxième bobine (202, 201) ;
dans lequel :
- la première borne d'entrée de l'élément unitaire intermédiaire (402) est reliée à la première borne de sortie de l'élément unitaire d'entrée (401) ;
- la deuxième borne d'entrée de l'élément unitaire intermédiaire (402) est reliée à la deuxième borne de sortie de l'élément unitaire d'entrée (401) ;
- la première borne de sortie de l'élément unitaire intermédiaire (402) est reliée à la première borne d'entrée de l'élément unitaire de sortie (403) ; et
- la deuxième borne de sortie de l'élément unitaire intermédiaire (402) est reliée à la deuxième borne d'entrée de l'élément unitaire de sortie (403), et
dans lequel l'élément unitaire d'entrée (401) est positionné spatialement entre l'élément unitaire intermédiaire (402) et l'élément unitaire de sortie (403).

2. Coupleur selon la revendication 1, dans lequel la première borne d'entrée de l'élément unitaire d'entrée (401) est une première entrée dudit premier assemblage (400 ; 501), et la deuxième borne d'entrée de l'élément unitaire d'entrée (401) est une deuxième entrée dudit premier assemblage (400 ; 501).

3. Coupleur selon la revendication 1 ou 2, dans lequel la première borne de sortie de l'élément unitaire de sortie (403) est une première sortie dudit premier assemblage (400 ; 501), et la deuxième borne de sortie de l'élément unitaire de sortie (403) est une deuxième sortie dudit premier assemblage (400 ; 501).

4. Coupleur selon la revendication 2 ou 3, dans lequel la première entrée dudit assemblage est configurée pour recevoir un premier signal, et la deuxième entrée dudit assemblage est configurée pour recevoir un deuxième signal égale au premier signal déphasé.

5. Coupleur selon la revendication 4, dans lequel le deuxième signal est le premier signal déphasé de quatre-vingt-dix degrés.

6. Coupleur selon la revendication 4, dans lequel le deuxième signal est le premier signal déphasé de cent quatre-vingt degrés.

7. Coupleur selon l'une quelconque des revendications 3 à 6 dans leur rattachement à la revendication 2, comprenant au moins un deuxième assemblage (400 ; 502) identique au premier assemblage (400 ; 501),
dans lequel la première sortie dudit premier assemblage (400 ; 501) est reliée à une première entrée dudit deuxième assemblage (400 ; 502), et
la deuxième sortie dudit premier assemblage (400 ; 501) est reliée à une deuxième entrée dudit deuxième assemblage (400 ; 502).

8. Coupleur selon l'une quelconque des revendications 1 à 7, dans lequel lesdits éléments unitaires ont tous les mêmes dimensions.

9. Coupleur selon l'une quelconque des revendications 1 à 7, dans lequel lesdits éléments unitaires ont des dimensions différentes.

10. Coupleur selon l'une quelconque des revendications 1 à 9, dans lequel lesdits éléments unitaires sont tous placés dans un même premier plan.

11. Coupleur selon l'une quelconque des revendications 1 à 9, dans lequel lesdits éléments unitaires sont tous placés dans des deuxièmes plans différents.

12. Coupleur selon la revendication 11, dans lequel lesdits éléments unitaires sont placés en forme d'escalier.

13. Coupleur selon l'une quelconque des revendications 1 à 12, dans lequel les premiers et deuxièmes bobines desdits éléments unitaires sont des enroulements de forme générale rectangulaire.

14. Coupleur selon l'une quelconque des revendications 1 à 12, dans lequel les premiers et deuxièmes bobines desdits éléments unitaires sont des enroulements de forme générale en zig-zag.

15. Coupleur selon l'une quelconque des revendications 1 à 14, étant un coupleur réversible.
